# EUROPEAN PATENT APPLICATION

(11) **EP 2 733 728 A1**
(43) Date of publication of application: **21.05.2014**
(21) Application number: 12814152.0
(22) Date of filing: 06.07.2012
(51) Int. Cl.: H01L 21/56, C09J 7/02, C09J 11/00, C09J 201/00, H01L 21/301, H01L 23/29, H01L 23/31

(54) **METHOD FOR MANUFACTURING ELECTRONIC COMPONENT AND ADHESIVE SHEET USED IN METHOD FOR MANUFACTURING ELECTRONIC COMPONENT**

(30) Priority: 15.07.2011 JP 2011156803
(71) Applicant: Nitto Denko Corporation, Ibaraki-shi, Osaka 567-8680 (JP)
(72) Inventor: HIRAYAMA, Takamasa, Ibaraki-shi Osaka 567-8680 (JP); SHIMOKAWA, Daisuke, Ibaraki-shi Osaka 567-8680 (JP)
(74) Representative: Grünecker, Kinkeldey, Stockmair & Schwanhäusser
(86) International application number: PCT/JP2012/067360
(87) International publication number: WO 2013/011850

(57) **Abstract**

A simplified production method for a chip-shaped electronic component such as a semiconductor chip is provided. The production method of the present invention includes: attaching a pressure-sensitive adhesive sheet to a substrate, the pressure-sensitive adhesive sheet including a base, a thermally expandable pressure-sensitive adhesive layer containing thermally expandable microspheres provided on one surface of the base, and a dielectric layer including a weak pressure-sensitive adhesive layer and an adhesive layer provided on another surface of the base in this order from a side of the base, so that the thermally expandable pressure-sensitive adhesive layer is placed on a side of the substrate; attaching and fixing a plurality of chip-shaped electronic components to a surface of the pressure-sensitive adhesive sheet on a side of the adhesive layer so that electrode surfaces of the plurality of chip-shaped electronic components are placed on the side of the adhesive layer; covering an entire surface of the plurality of chip-shaped electronic components excluding fixed surfaces with a protective substance to obtain an encapsulated body including the plurality of chip-shaped electronic components; subjecting the pressure-sensitive adhesive sheet to heating treatment to cause the thermally expandable microspheres in the thermally expandable pressure-sensitive adhesive layer to expand to decrease an adhesion of the thermally expandable pressure-sensitive adhesive layer and peeling the thermally expandable pressure-sensitive adhesive layer from the substrate; peeling the weakpressure-sensitive adhesive layer from the adhesive layer to obtain a laminate of the adhesive layer and the encapsulated body; and cutting the laminate between the plurality of chip-shaped electronic components to separate individual chip-shaped electronic components.

## Description

### Technical Field

The present invention relates to a production method for an electronic component, and to a pressure-sensitive adhesive sheet to be used in the production method.

### Background Art

In production of a semiconductor chip, a package system called a wafer level chip size package (WL-CSP) in which packaging is performed in a wafer state for the purpose of high-density packaging is drawing attention. According to the WL-CSP, a wafer is subjected to dicing after redistribution, formation of terminals, and the like are performed on the wafer, and hence a semiconductor package reduced in size almost to a chip size can be obtained.

In this connection, a plurality of circuit patterns formed on one wafer may include defective products. In this case, when processes such as redistribution are performed on the wafer in a collective manner without discriminating defective products from non-defective products, a process performed with respect to the defective products becomes waste, resulting in an increase in production cost of the non-defective products which can be shipped. In order to solve the problem, there has been proposed a production method involving performing formation of terminals and the like after only non-defective products are selected (Patent Literature 1).

Further, the WL-CSP requires many complicated processing steps. For example, the step of forming a redistribution layer generally includes some steps such as first interlayer insulating layer formation, seed metal deposition, photoresist pattern formation, plating, photoresist removal, and seed metal etching, and second interlayer insulating layer formation. Therefore, in the WL-CSP, there is a strong demand for simplification of the steps as well as a reduction in production cost. More specifically, according to a production method for a CSP, a dielectric protective layer is provided on a pattern surface and bumps are formed thereon. However, a thickness of a semiconductor chip is becoming small, and hence with only a thickness of such dielectric protective layer, it is highly probable that the semiconductor chip may be broken. Further, the semiconductor chip is often used in a severe environment, which makes it difficult to ensure reliability. Thus, there is a demand for increasing the thickness of the dielectric protective layer. However, in a conventional production method, which involves applying a liquid resin as a dielectric protective layer onto a pattern surface of a semiconductor chip through use of spin coating, there are problems in that it is difficult to increase a thickness of the dielectric protective layer, and that the use of the spin coating results in a reduction in coating yield of the dielectric protective layer and an increase in use amount of the resin.

### Citation List

### Patent Literature

[PTL 1] JP 2001-308116 A

### Summary of Invention

### Technical Problem

The present invention has been made to solve the above-mentioned problems, and an object of the present invention is to reduce a production cost of a chip-shaped electronic component such as a semiconductor chip and simplify a production method therefor.

### Means for Solving The Problem

The present invention provides a production method for an electronic component. The production method includes:
attaching a pressure-sensitive adhesive sheet to a substrate, the pressure-sensitive adhesive sheet including a base, a thermally expandable pressure-sensitive adhesive layer containing thermally expandable microspheres provided on one surface of the base, and a dielectric layer including a weak pressure-sensitive adhesive layer and an adhesive layer provided on another surface of the base in this order from a side of the base, so that the thermally expandable pressure-sensitive adhesive layer is placed on a side of the substrate;
attaching and fixing a plurality of chip-shaped electronic components to a surface of the pressure-sensitive adhesive sheet on a side of the adhesive layer so that electrode surfaces of the plurality of chip-shaped electronic components are placed on the side of the adhesive layer;
covering an entire surface of the plurality of chip-shaped electronic components excluding fixed surfaces with a protective substance to obtain an encapsulated body including the plurality of chip-shaped electronic components;
subjecting the pressure-sensitive adhesive sheet to heating treatment to cause the thermally expandable microspheres in the thermally expandable pressure-sensitive adhesive layer to expand to decrease an adhesion of the thermally expandable pressure-sensitive adhesive layer and peeling the thermally expandable pressure-sensitive adhesive layer from the substrate;
peeling the weak pressure-sensitive adhesive layer from the adhesive layer to obtain a laminate of the adhesive layer and the encapsulated body; and
cutting the laminate between the plurality of chip-shaped electronic components to separate individual chip-shaped electronic components.

In a preferred embodiment, the protective substance contains a thermosetting resin or a thermoplastic resin, and a heating temperature in the heating treatment is equal to or higher than a curing temperature of the thermosetting resin or is equal to or lower than a softening temperature of the thermoplastic resin.

According to another aspect of the present invention, a pressure-sensitive adhesive sheet to be used in the production method for an electronic component is provided. The pressure-sensitive adhesive sheet includes:
a base;
a thermally expandable pressure-sensitive adhesive layer containing thermally expandable microspheres provided on one surface of the base; and
a dielectric layer including a weak pressure-sensitive adhesive layer and an adhesive layer provided on another surface of the base in this order from a side of the base.

In a preferred embodiment, a dielectric constant of the adhesive layer is 5 or less.

In a preferred embodiment, a water absorption rate of the adhesive layer is 2% or less.

In a preferred embodiment, an adhesion of the weak pressure-sensitive adhesive layer with respect to the adhesive layer in an atmosphere of 23°C is 3 N/20 mm or less.

In a preferred embodiment, the adhesion of the weak pressure-sensitive adhesive layer with respect to the adhesive layer in an atmosphere of 100°C is 2 N/20 mm or less.

In a preferred embodiment, the protective substance contains a thermosetting resin, and an expansion starting temperature of the thermally expandable microspheres is equal to or higher than a curing temperature of the thermosetting resin.

### Advantageous Effects of Invention

According to the present invention, through use of a pressure-sensitive adhesive sheet having a predetermined configuration, a dielectric protective layer can be formed easily on an electrode surface of a chip-shaped electronic component. The dielectric protective layer can serve as an insulating layer in formation of the above-mentioned redistribution layer, which leads to simplification of the step of forming a redistribution layer in a production method for a chip-shaped electronic component. Further, in the present invention, a further process with respect to a defective product can be avoided by selecting only a non-defective product as a chip-shaped electronic component and covering the non-defective product with a protective substance to obtain an encapsulated body. Further, the encapsulated body can be peeled from a substrate without being damaged by decreasing the adhesion of a thermally expandable pressure-sensitive adhesive layer sufficiently by heating treatment. Consequently, a yield is enhanced, and hence a production cost can be reduced.

### Brief Description of Drawings

[FIG. 1] A schematic cross-sectional view of a pressure-sensitive adhesive sheet of the present invention.
[FIG. **2**] A schematic view illustrating a production method of the present invention.

### Description of Embodiments

### A. Pressure-sensitive adhesive sheet

In one aspect, the present invention provides a pressure-sensitive adhesive sheet. The pressure-sensitive adhesive sheet of the present invention includes a base, a thermally expandable pressure-sensitive adhesive layer containing thermally expandable microspheres provided on one surface of the base, and a dielectric layer including a weak pressure-sensitive adhesive layer and an adhesive layer provided on the other surface of the base in this order from the base side. The pressure-sensitive adhesive sheet of the present invention is suitably used in a production method for an electronic component. The production method typically includes: attaching the pressure-sensitive adhesive sheet of the present invention to a substrate so that the thermally expandable pressure-sensitive adhesive layer is placed on the substrate side; attaching and fixing a plurality of chip-shaped electronic components to a surface of the pressure-sensitive adhesive sheet on the adhesive layer side so that electrode surfaces of the plurality of chip-shaped electronic components are placed on the adhesive layer side; covering an entire surface excluding fixed surfaces of the plurality of chip-shaped electronic components with a protective substance to obtain an encapsulated body including the plurality of chip-shaped electronic components; subjecting the pressure-sensitive adhesive sheet to heating treatment to cause the thermally expandable microspheres in the thermally expandable pressure-sensitive adhesive layer to expand to decrease the adhesion of the thermally expandable pressure-sensitive adhesive layer, and peeling the thermally expandable pressure-sensitive adhesive layer from the substrate; peeling the weak pressure-sensitive adhesive layer from the adhesive layer to obtain a laminate of the adhesive layer and the encapsulated body; and cutting the laminate between the plurality of chip-shaped electronic components to separate individual chip-shaped electronic components. The pressure-sensitive adhesive sheet of the present invention is hereinafter described in detail. A production method involving using the pressure-sensitive adhesive sheet of the present invention is described in detail in Section B.

### A-1. Entire configuration of pressure-sensitive adhesive sheet

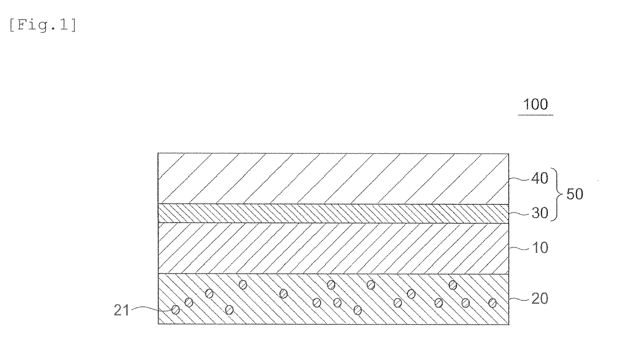

FIG. **1** is a schematic cross-sectional view of a pressure-sensitive adhesive sheet according to a preferred embodiment of the present invention. Apressure-sensitive adhesive sheet **100** includes a base **10**, a thermally expandable pressure-sensitive adhesive layer **20** provided on one surface of the base **10**, and a dielectric layer **50** including a weak pressure-sensitive adhesive layer **30** and an adhesive layer **40** provided on the other surface of the base **10** in this order from the base **10** side. The thermally expandable pressure-sensitive adhesive layer **20** contains thermally expandable microspheres **21**. Although not shown, as required, the surfaces of the pressure-sensitive adhesive sheet may be protected until it is put into practical use by providing a separator on a side of the thermally expandable pressure-sensitive adhesive layer **20** on which the base **10** is not provided and/or on a side of the adhesive layer **40** on which the weak pressure-sensitive adhesive layer **30** is not provided.

The thickness of the pressure-sensitive adhesive sheet may be appropriately set depending upon the purpose and the like. The thickness is generally 25 to 300 µm, preferably 60 to 200 µm.

### A-2. Base

The base 10 may be formed of any appropriate material as long as it can support the thermally expandable pressure-sensitive adhesive layer and the dielectric layer provided on both sides thereof. Examples of the material include polyolefins such as low density polyethylene, linear polyethylene, medium density polyethylene, high density polyethylene, ultra low density polyethylene, random copolymerization polypropylene, block copolymerization polypropylene, homopolypropylene, polybutene, and polymethylpentene, an ethylene-vinyl acetate copolymer, an ionomer resin, an ethylene-(meth)acrylic acid copolymer, an ethylene-(meth)acrylic acid ester (random or alternating) copolymer, an ethylene-butene copolymer, an ethylene-hexene copolymer, polyurethane, polyesters such as polyethylene terephthalate and polyethylene naphthalate, polycarbonate, polyimide, polyether ether ketone, polyether imide, polyamide, wholly aromatic polyamide, polyphenyl sulfide, aramide (paper), glass, glass cloth, a fluororesin, polyvinyl chloride, polyvinylidene chloride, a cellulose-based resin, a silicone resin, a metal (foil), and paper. They may be used alone or in combination.

Further examples of the material for the base include polymers such as cross-linked products of the above-mentioned resins. The plastic film may be used without being stretched, or as required, may be uniaxially or biaxially stretched before use.

In order to enhance adhesiveness, retention property, and the like with respect to an adjacent layer, the surface of the base may be subjected to conventional surface treatment, for example, chemical or physical treatment such as chromic acid treatment, ozone exposure, flame exposure, high-voltage shock exposure, or ionizing radiation treatment, or coating treatment with a primer (forexample, a pressure-sensitive adhesive substance).

In order to impart antistatic performance to the base, a vapor deposition layer of a conductive substance with a thickness of about 30 to 500 Å made of a metal, an alloy, or an oxide thereof may be provided on the base. The base may be of a single layer or a complex layer including two or more kinds of layers. It should be noted that when the weak pressure-sensitive adhesive layer is radiation-curable, it is preferred that the base be made of a material which at least partially transmits a radiation such as an X-ray, UV light, or an electron beam.

The thickness of the base may be appropriately set depending upon the purpose. The thickness is generally about 5 to 200 µm.

### A-3. Thermally expandable pressure-sensitive adhesive layer

The thermally expandable pressure-sensitive adhesive layer **20** contains a pressure-sensitive adhesive for imparting pressure-sensitive adhesive property and thermally expandable microspheres (microcapsules) for imparting thermal expansion property. The pressure-sensitive adhesive sheet **100** including such thermally expandable pressure-sensitive adhesive layer **20** is subjected to heating treatment to cause the thermally expandable microspheres **21** to foam and/or expand, to thereby reduce a contact area between the thermally expandable pressure-sensitive adhesive layer **20** and a substrate **200** and to decrease an adhesion sufficiently. Consequently, the substrate **200** is peeled easily, and hence, in the case where an encapsulated body is formed on the adhesive layer **40**, the encapsulated body can be peeled without being damaged.

The center line surface roughness of the surface of the thermally expandable pressure-sensitive adhesive layer before the heating is preferably 0.4 µm or less (e.g., about 0.02 to 0.4 µm), more preferably 0. 3 µm or less (e.g., about 0.02 to 0. 3 µm), still more preferably 0.2 µm or less (e.g., about 0.02 to 0.2 µm). Further, the maximum roughness of the surface of the thermally expandable pressure-sensitive adhesive layer before the heating is preferably 5 µm or less (e.g., about 0.1 to 5 µm), more preferably 3 µm or less (e.g., about 0.5 to 3 µm). The center line average roughness and maximum roughness of the surface of the thermally expandable pressure-sensitive adhesive layer before the heating may be adjusted by appropriately selecting the thickness of the thermally expandable pressure-sensitive adhesive layer and the particle diameter of the thermally expandable microspheres to be added to the pressure-sensitive adhesive layer.

The pressure-sensitive adhesive is preferably one that does not restrict the foaming and/or expansion of the thermally expandable microspheres at the time of the heating. As the pressure-sensitive adhesive, there may be used, alone or in combination, for example, known pressure-sensitive adhesives such as a rubber-based pressure-sensitive adhesive, an acrylic pressure-sensitive adhesive, a vinyl alkyl ether-based pressure-sensitive adhesive, a silicone-based pressure-sensitive adhesive, a polyester-based pressure-sensitive adhesive, a polyamide-based pressure-sensitive adhesive, a urethane-based pressure-sensitive adhesive, and a styrene-diene block copolymer-based pressure-sensitive adhesive, and creep characteristic-improved pressure-sensitive adhesives each obtained by blending a hot-melt resin having a melting point of about 200°C or less into any of those pressure-sensitive adhesives (see, for example, JP 56-61468 A, JP 61-174857 A, JP 63-17981 A, and JP 56-13040 A). The pressure-sensitive adhesive may contain, in addition to an adherent component (base polymer), appropriate additives such as a cross-linking agent (such as polyisocyanate or an alkyl etherified melamine compound), a tackifier (such as a rosin derivative resin, a polyterpene resin, a petroleum resin, or an oil-soluble phenol resin), a plasticizer, a filler, and an antioxidant.

As the pressure-sensitive adhesive, there is generally used: a rubber-based pressure-sensitive adhesive containing, as a base polymer, a natural rubber or any of various synthetic rubbers; an acrylic pressure-sensitive adhesive containing, as a base polymer, an acrylic polymer (homopolymer or copolymer) using, as a monomer component, one kind or two or more kinds of (meth) acrylic acid alkyl esters (such as C₁₋₂₀ alkyl esters including a methyl ester, an ethyl ester, a propyl ester, an isopropyl ester, a butyl ester, an isobutyl ester, an s-butyl ester, a t-butyl ester, a pentyl ester, a hexyl ester, a heptyl ester, an octyl ester, a 2-ethylhexyl ester, an isooctyl ester, an isodecyl ester, a dodecyl ester, a tridecyl ester, a pentadecyl ester, a hexadecyl ester, a heptadecyl ester, an octadecyl ester, a nonadecyl ester, and an eicosyl ester); or the like. It should be noted that the term " (meth) acrylic acid alkyl ester" as used herein refers to an acrylic acid alkyl ester and/or a methacrylic acid alkyl ester.

The acrylic polymer may contain a unit corresponding to an additional monomer component copolymerizable with the (meth)acrylic acid alkyl esters as required for the purpose of modifying a cohesion, heat resistance, cross-linking property, or the like. Examples of such monomer component include: carboxyl group-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl group-containing monomers such as hydroxyethyl (meth)acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth)acrylate, and (4-hydroxymethylcyclohexyl)methyl methacrylate; sulfonic acid group-containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; (N-substituted) amide-based monomers such as (meth)acrylamide, N,N-dimethyl(meth)acrylamide, N-butyl(meth)acrylamide, N-methylol(meth)acrylamide, and N-methylolpropane(meth)acrylamide; aminoalkyl (meth)acrylate-based monomers such as aminoethyl (meth)acrylate, N,N-dimethylaminoethyl (meth)acrylate, and t-butylaminoethyl (meth) acrylate; alkoxyalkyl (meth) acrylate-based monomers such as methoxyethyl (meth)acrylate and ethoxyethyl (meth)acrylate; maleimide-based monomers such as N-cyclohexylmaleimide, N-isopropylmaleimide, N-laurylmaleimide, and N-phenylmaleimide; itaconimide-based monomers such as N-methylitaconimide, N-ethylitaconimide, N-butylitaconimide, N-octylitaconimide, N-2-ethylhexylitaconimide, N-cyclohexylitaconimide, and N-laurylitaconimide; succinimide-based monomers such as N-(meth)acryloyloxymethylenesuccinimide, N-(meth)acryloyl-6-oxyhexamethylenesuccinimide, and N-(meth)acryloyl-8-oxyoctamethylenesuccinimide; vinyl-based monomers such as vinyl acetate, vinyl propionate, N-vinylpyrrolidone, methylvinylpyrrolidone, vinylpyridine, vinylpiperidone, vinylpyrimidine, vinylpiperazine, vinylpirazine, vinylpyrrole, vinylimidazole, vinyloxazole, vinylmorpholine, N-vinylcarboxylic acid amides, styrene, α-methylstyrene, and N-vinylcaprolactam; cyanoacrylate monomers such as acrylonitrile and methacrylonitrile; epoxy group-containing acrylic monomers such as glycidyl (meth)acrylate; glycol-based acrylic ester monomers such as polyethylene glycol (meth)acrylate, polypropylene glycol (meth)acrylate, methoxyethylene glycol (meth)acrylate, and methoxypolypropylene glycol (meth)acrylate; acrylic acid ester-based monomers each having a heterocyclic ring, a halogen atom, a silicon atom, or the like, such as tetrahydrofurfuryl (meth)acrylate, fluorine (meth)acrylate, and silicone (meth)acrylate; polyfunctional monomers such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate, and urethane acrylate; olefin-based monomers such as isoprene, butadiene, and isobutylene; and vinyl ether-based monomers such as vinyl ether. Those monomer components may be used alone or in combination.

It should be noted that a more preferred pressure-sensitive adhesive from the viewpoint of a balance between an appropriate adhesion before the heating treatment and a reduction in adhesion after the heating treatment is a pressure-sensitive adhesive based on a polymer having a dynamic modulus of elasticity at ordinary temperature to 150 °C in the range of 50, 000 to 10, 000, 000 dyn/cm².

Examples of the thermally expandable microspheres include microspheres each including a substance that is easily gasified by heating to expand, such as isobutane, propane, orpentane, in an elastic shell. The shell is often formed of a hot-melt substance or a substance to be broken by thermal expansion. Examples of the substance for forming the shell include a vinylidene chloride-acrylonitrile copolymer, polyvinyl alcohol, polyvinyl butyral, polymethyl methacrylate, polyacrylonitrile, polyvinylidenechloride, and polysulfone. The thermally expandable microspheres may be produced by a conventional method such as a coacervation method or an interfacial polymerization method. Alternatively, for example, a commercially available product such as Microsphere (trade name, manufactured by Matsumoto Yushi-Seiyaku Co., Ltd.) may be used.

It is preferred that the thermally expandable microspheres have such appropriate strength that the microspheres do not rupture until the coefficient of volumetric expansion thereof becomes 5 times or more, especially 7 times or more, particularly 10 times or more. In the case of using such thermally expandable microspheres, the adhesion of the thermally expandable pressure-sensitive adhesive layer may be decreased efficiently by heating treatment.

It is preferred that the particle diameter of the thermally expandable microspheres satisfy a relationship: "thickness of thermally expandable pressure-sensitive adhesive layer ≥ particle diameter of thermally expandable microspheres" for the purpose of satisfying the center line average roughness and maximum roughness of the surface of the thermally expandable pressure-sensitive adhesive layer before the heating. When the particle diameter of the thermally expandable microspheres is larger than the thickness of the thermally expandable pressure-sensitive adhesive layer, the surface roughness of the thermally expandable pressure-sensitive adhesive layer becomes large, and an effective contact area with respect to an adherend becomes small. The particle diameter of the thermally expandable microspheres may be adjusted in the course of generation of the thermally expandable microspheres or by means such as classification after generation of the thermally expandable microspheres.

When the protective substance contains a thermosetting resin, the expansion starting temperature of the thermally expandable microspheres is preferably equal to or higher than the curing temperature of the protective substance, more preferably higher than the curing temperature by 10°C or more. When the expansion starting temperature falls within the range, the protective substance can be cured without causing the thermally expandable microspheres to expand and/or foam, and hence chip-shaped electronic components can be reliably retained adherently even during thermal curing of the protective substance. Then, the thermally expandable pressure-sensitive adhesive layer can be peeled from the substrate without damaging the encapsulated body by heating the layer to a temperature equal to or higher than the expansion starting temperature after the protective substance is cured to decrease an adhesion of the thermally expandable pressure-sensitive adhesive layer.

The compounding amount of the thermally expandable microspheres in the thermally expandable pressure-sensitive adhesive layer may be appropriately set depending upon the expansion magnification, reduction in adhesion, and the like of the thermally expandable pressure-sensitive adhesive layer. In general, the compounding amount is, for example, 1 to 150 parts by weight, preferably 10 to 130 parts by weight, more preferably 25 to 100 parts by weight with respect to 100 parts by weight of a base polymer for forming the thermally expandable pressure-sensitive adhesive layer.

The thermally expandable pressure-sensitive adhesive layer may be formed by any appropriate method. Examples thereof include: a method involving preparing a coating solution containing a pressure-sensitive adhesive and thermally expandable microspheres through use of a solvent as required, and applying the coating solution onto the base; and a method involving applying the coating solution onto an appropriate separator (e.g., release paper) to form a thermally expandable pressure-sensitive adhesive layer and transferring the thermally expandable pressure-sensitive adhesive layer to a base. The thermally expandable pressure-sensitive adhesive layer may be a single layer or a complex layer.

The thickness of the thermally expandable pressure-sensitive adhesive layer is preferably 300 µm or less, more preferably 100 µm or less. Further, the thickness of the thermally expandable pressure-sensitive adhesive layer is preferably 5 µm or more, more preferably 10 µm or more, still more preferably 15 µm or more. When the thickness is too large, at the time of the peeling of the thermally expandable pressure-sensitive adhesive layer after heating treatment, cohesion failure occurs, a pressure-sensitive adhesive remains on an adherend (a base or a substrate), and the adherend is liable to be contaminated. On the other hand, when the thickness is too small, the deformation degree of the thermally expandable pressure-sensitive adhesive layer by heating treatment is small, the adhesion is not decreased smoothly, and it is necessary to excessively decrease the particle diameter of the thermally expandable microspheres to be added.

### A-4. Dielectric layer

The dielectric layer **50** includes the weak pressure-sensitive adhesive layer **30** and the adhesive layer **40** in this order from the base **10** side.

### A-4-1. Weak pressure-sensitive adhesive layer

The weak pressure-sensitiveadhesivelayer **30** has satisfactory adhesiveness and peel property with respect to the adhesive layer **40** in an appropriate balance. Therefore, at the time of attaching and fixing chip-shaped electronic components, the weak pressure-sensitive adhesive layer **30** comes into close contact with the adhesive layer **40** to reinforce its retention force, and can be easily peeled from the adhesive layer **40** after an encapsulated body is formed.

The adhesion (90°-peel value, peel rate: 300 mm/min) of the weak pressure-sensitive adhesive layer with respect to the adhesive layer in an atmosphere of 23°C is preferably as small as possible, preferably 3 N/20 mm or less, more preferably 2.5 N/20 mm or less, still more preferably 2 N/20 mm or less. The lower limit of the adhesion is, for example, 0.02 N/20 mm. With such small adhesion (peel value), peel property with respect to the surface of the adhesive layer increases, and hence the weak pressure-sensitive adhesive layer can be peeled sufficiently from the surface of the adhesive layer. Consequently, the thickness of the dielectric protective layer formed of the adhesive layer can be controlled with good accuracy.

The adhesion (90°-peel value, peel rate: 300 mm/min) of the weak pressure-sensitive adhesive layer with respect to the adhesive layer in an atmosphere of 100°C is preferably as small as possible, preferably 2 N/20 mm or less, more preferably 1.8 N/20 mm or less, still more preferably 1.5 N/20 mm or less. The lower limit of the adhesion is, for example, 0. 02 N/20 mm. With such small adhesion (peel value), peel property with respect to the surface of the adhesive layer increases, and hence the weak pressure-sensitive adhesive layer can be peeled sufficiently from the surface of the adhesive layer. Consequently, the thickness of the dielectric protective layer formed of the adhesive layer can be controlled with good accuracy.

A radiation-curable pressure-sensitive adhesive may be preferably used as an adhesive to be used for forming the weak pressure-sensitive adhesive layer. This is because the radiation-curable pressure-sensitive adhesive can easily increase a cross-linking degree to decrease its adhesion by irradiation with a radiation such as UV light. Thus, a weak pressure-sensitive adhesive layer having a desired adhesion can be easily formed by curing the radiation-curable pressure-sensitive adhesive by irradiation with a radiation.

As the radiation-curable pressure-sensitive adhesive, one having a radiation-curable functional group such as a carbon-carbon double bond and exhibiting pressure-sensitive adhesive property may be used without any particular limitation. Examples thereof may include addition-type radiation-curable pressure-sensitive adhesives obtained by compounding radiation-curable monomer components and oligomer components into general pressure-sensitive adhesives such as an acrylic pressure-sensitive adhesive and a rubber-based pressure-sensitive adhesive. As the pressure-sensitive adhesive, an acrylic pressure-sensitive adhesive containing an acrylic polymer as a base polymer is preferred from the viewpoints of, for example, cleansing and cleaning properties with ultrapure water or an organic solvent such as an alcohol of an electronic component whose contamination is not desired, such as a semiconductor wafer or glass.

Examples of the acrylic polymer include an acrylic polymer using, as a monomer component, one kind or two or more kinds of (meth) acrylic acid alkyl esters (such as linear or branched alkyl esters the alkyl group of each of which has 1 to 30 carbon atoms, particularly 4 to 18 carbon atoms, including a methyl ester, an ethyl ester, a propyl ester, an isopropyl ester, a butyl ester, an isobutyl ester, an s-butyl ester, a t-butyl ester, a pentyl ester, an isopentyl ester, a hexyl ester, a heptyl ester, an octyl ester, a 2-ethylhexyl ester, an isooctyl ester, a nonyl ester, a decyl ester, an isodecyl ester, an undecyl ester, a dodecyl ester, a tridecyl ester, a tetradecyl ester, a hexadecyl ester, an octadecyl ester, and an eicosyl ester) and (meth) acrylic acid cycloalkyl esters (such as a cyclopentyl ester and a cyclohexyl ester).

The acrylic polymer may contain a unit corresponding to an additional monomer copolymerizable with the (meth)acrylic acid alkyl ester or cycloalkyl ester, as required, for the purpose of modifying a cohesion, heat resistance, and the like. The copolymerizable additional monomers may be used alone or in combination. The use amount of the copolymerizable additional monomer is preferably 40% by weight or less of the total monomer components.

Further, the acrylic polymer may contain a polyfunctional monomer as a monomer component for copolymerization, as required, for the purpose of cross-linking. The polyfunctional monomers may be used alone or in combination. The use amount of the polyfunctional monomer is preferably 30% by weight or less of the total monomer components from the viewpoint of an adhesion characteristic or the like.

Preferred examples of the copolymerizable additional monomer and polyfunctional monomer may include additional monomer components copolymerizable with the (meth) acrylic acid alkyl ester described in Section A-3.

The acrylic polymer is obtained by polymerizing a single monomer or a mixture of two or more kinds of monomers. The polymerization may be performed by any mode such as solution polymerization, emulsion polymerization, mass polymerization, or suspension polymerization. It is preferred that the content of a low-molecular-weight substance be small from the viewpoint of preventing the adhesive layer from being contaminated at the time of peeling. From this viewpoint, the number average molecular weight of the acrylic polymer is preferably about 300,000 or more, more preferably about 400,000 to 3,000,000.

Further, the pressure-sensitive adhesive can also adopt an external cross-linking agent appropriately so as to increase the number average molecular weight of an acrylic polymer or the like as a base polymer. As specific means for an external cross-linking method, there is given a method involving adding a so-called cross-linking agent, such as a polyisocyanate compound, an epoxy compound, an aziridine compound, or a melamine-based cross-linking agent to allow the pressure-sensitive adhesive to react with the cross-linking agent. In the case of using an external cross-linking agent, the use amount thereof is appropriately determined depending upon a balance with the base polymer to be cross-linked, and further, an intended use as a pressure-sensitive adhesive. In general, the external cross-linking agent is compounded in an amount of preferably about 5 parts by weight or less, more preferably 0.1 to 5 parts by weight with respect to 100 parts by weight of the base polymer. Further, as required, various conventionally known additives such as a tackifier and an antioxidant may be used in the pressure-sensitive adhesive in addition to the above-mentioned components.

Examples of the radiation-curable monomer component include a urethane oligomer, urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, and 1,4-butanediol di(meth)acrylate.

Examples of the radiation-curable oligomer component include various oligomers such as urethane-based, polyether-based, polyester-based, polycarbonate-based, and polybutadiene-based oligomers. As the oligomer, one having a molecular weight in the range of about 100 to 30,000 is appropriate.

The compounding amount of the radiation-curable monomer component and oligomer component may be appropriately determined so as to decrease the adhesion of the weak pressure-sensitive adhesive layer depending upon the kind of the weakpressure-sensitive adhesive layer. In general, the compounding amount is, for example, 5 to 500 parts by weight, preferably about 40 to 150 parts by weight with respect to 100 parts by weight of the base polymer such as the acrylic polymer constituting the pressure-sensitive adhesive.

Further, examples of the radiation-curable pressure-sensitive adhesive include an internal radiation-curable pressure-sensitive adhesive using a base polymer having a carbon-carbon double bond in a polymer side chain or main chain or main chain terminal, in addition to the above-mentioned addition-type radiation-curable pressure-sensitive adhesive. The internal radiation-curable pressure-sensitive adhesive does not need to contain an oligomer component or the like as a low-molecular-weight component or does not contain a large amount of the oligomer component or the like. Therefore, the internal radiation-curable pressure-sensitive adhesive is preferred as being able to form a weak pressure-sensitive adhesive layer having a stable layer structure without the oligomer component or the like moving in the pressure-sensitive adhesive with time.

As the base polymer having a carbon-carbon double bond, one having a carbon-carbon double bond and having pressure-sensitive adhesive property may be used without any particular limitation. Such base polymer is preferably one having an acrylic polymer as a basic skeleton. An example of the basic skeleton of the acrylic polymer is the acrylic polymer as illustrated above.

Any appropriate method may be adopted as a method of introducing a carbon-carbon double bond into the acrylic polymer. For example, a carbon-carbon double bond can be easily introduced into a polymer side chain in terms of molecular design. Specifically, there is given a method involving copolymerizing a monomer having a functional group in an acrylic polymer in advance, and thereafter, subjecting a compound having a functional group capable of reacting with the functional group of the monomer and a carbon-carbon double bond to a condensation or addition reaction while keeping a radiation-curing property of the carbon-carbon double bond.

A combination of the functional groups is exemplified by: a carboxylic acid group and an epoxy group; a carboxylic acid group and an aziridyl group; and a hydroxyl group and an isocyanate group. Of those combinations of the functional groups, a combination of a hydroxyl group and an isocyanate group is suitable because of easiness with which the reaction is monitored. Further, the functional groups may be present on any of the acrylic polymer and the compound as long as the acrylic polymer having a carbon-carbon double bond is produced with the combination of the functional groups. In the preferred combination, it is preferred that the acrylic polymer have the hydroxyl group and the compound have the isocyanate group. In this case, examples of the isocyanate compound having a carbon-carbon double bond include methacryloyl isocyanate, 2-methacryloyloxyethyl isocyanate, and m-isopropenyl-α,α-dimethylbenzyl isocyanate. In addition, as the acrylic polymer, there is used one obtained by copolymerizing a hydroxy group-containing monomer, an ether-based compound such as 2-hydroxyethyl vinyl ether, 4-hydroxybutyl vinyl ether, or diethylene glycol monovinyl ether, and the like.

As the internal radiation-curable pressure-sensitive adhesive, the base polymer (particularly an acrylic polymer) having a carbon-carbon double bond may be used alone. However, the radiation-curable monomer component and oligomer component may also be compounded in the internal radiation-curable pressure-sensitive adhesive to such a degree as not to degrade characteristics. The radiation-curable oligomer component and the like are generally used in the range of 30 parts by weight, preferably in the range of 0 to 10 parts by weight with respect to 100 parts by weight of the base polymer.

Whentheradiation-curablepressure-sensitiveadhesive is cured with UV light or the like, a photopolymerization initiator is incorporated into the pressure-sensitive adhesive. Examples of the photopolymerization initiator include: α-ketol-based compounds such as 4-(2-hydroxyethoxy)phenyl (2-hydroxy-2-propyl) ketone, α-hydroxy-α,α'-dimethylacetophenone, 2-methyl-2-hydroxypropiophenone, and 1-hydroxycyclohexyl phenyl ketone; acetophenone-based compounds such as methoxyacetophenone, 2,2-dimethoxy-2-phenylacetophenone, 2,2-diethoxyacetophenone, and 2-methyl-1-[4-(methylthio)-phenyl]-2-morpholinopropan-1-one; benzoin ether-based compounds such as benzoin ethyl ether, benzoin isopropyl ether, and anisoin methyl ether; ketal-based compounds such as benzyl dimethyl ketal; aromatic sulfonyl chloride-based compounds such as 2-naphthalenesulfonyl chloride; photoactive oxime-based compounds such as 1-phenone-1,1-propanedione-2-(o-ethoxycarbonyl)oxime; benzophenone-based compounds such as benzophenone, benzoylbenzoic acid, and 3,3'-dimethyl-4-methoxybenzophenone; thioxanthone-based compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acyl phosphine oxides; and acyl phosphonates. The compounding amount of the photopolymerization initiator is, for example, about 0.05 to 20 parts by weight with respect to 100 parts by weight of the base polymer such as the acrylic polymer constituting the pressure-sensitive adhesive.

Further, examples of the radiation-curable pressure-sensitive adhesive include rubber-based pressure-sensitive adhesives and acrylic pressure-sensitive adhesives disclosed in JP 60-196956 A each containing a photopolymerizable compound such as an addition polymerizable compound having two or more unsaturated bonds or an alkoxysilane having an epoxy group, and a photopolymerization initiator such as a carbonyl compound, an organosulfur compound, a peroxide, an amine, or an onium salt-based compound.

The weak pressure-sensitive adhesive layer may be formed by a method involving directly applying the radiation-curable pressure-sensitive adhesive onto a base surface, followed by drying, a method involving applying the pressure-sensitive adhesive onto a separator, followed by drying, to form a pressure-sensitive adhesive layer, and transferring the pressure-sensitive adhesive layer onto a base, or the like. In this case, as required, the adhesion of the weak pressure-sensitive adhesive layer can be adjusted in a desired range by irradiation with a radiation.

The thickness of the weak pressure-sensitive adhesive layer may be appropriately set depending upon the purpose. From the viewpoints of fixing and retention properties and the like of the adhesive layer, the thickness is preferably about 1 to 50 µm, more preferably 2 to 30 µm, still more preferably 5 to 25 µm.

### A-4-2. Adhesive layer

The adhesive layer **40** comes into close contact with chip-shaped electronic components to be attached to a surface of the adhesive layer **40** and fixes the chip-shaped electronic components. Further, when a redistribution layer is formed on the chip-shaped electronic components, the adhesive layer serves as a dielectric protective layer for electrode surfaces of the chip-shaped electronic components, and hence it is not necessary to form an insulating layer separately.

The dielectric constant of the adhesive layer is preferably 5 or less, more preferably 4 or less, still more preferably 3 or less. When the dielectric constant falls within the range, the adhesive layer can suitably function as a dielectric protective layer for electrode surfaces of chip-shaped electronic components.

The water absorption rate of the adhesive layer is preferably 2% by weight or less, more preferably 1.5% by weight or less, still more preferably 1% by weight or less. When the water absorption rate falls within the range, occurrence of voids and the like can be avoided in a reflow step.

An adhesive for forming the adhesive layer may be a general die adhesive, preferably a die adhesive capable of being molded into a sheet shape. Specifically, for example, a die adhesive formed of a thermoplastic resin or a thermosetting resin may be suitablyused. The die adhesives may be used alone or in combination. Further, it is preferred that the die adhesive be capable of achieving the adhesion of chip-shaped electronic components at 70°C or less, and it is more preferred that the die adhesive be capable of achieving the adhesion of the chip-shaped electronic components at ordinary temperature.

Examples of the thermoplastic resin to be used as the die adhesive (thermoplastic die adhesive) include a saturated polyester resin, a thermoplastic polyurethane-based resin, an amide-based resin (nylon-based resin), and an imide-based resin. Further, examples of the thermosetting resin (thermosetting die adhesive) include an epoxy resin, an unsaturated polyester resin, a thermosetting acrylic resin, and a phenolic resin. The thermosetting resin is suitably a thermosetting resin from which a solvent has been removed and which has formed into a sheet and brought into a B-stage. It should be noted that a mixture of any such thermosetting resin and any such thermoplastic resin may also be used in a state of a B-stage. Further, in the present invention, a resin having a high glass transition temperature such as a silicone-based, rubber-based, urethane-based, imide-based, or acrylic resin may also be used as the die adhesive.

The adhesive layer may have a multilayer structure of two or more layers in which thermoplastic resins having different glass transition temperatures and/or thermosetting resins having different thermal curing temperatures are combined appropriately. Further, the adhesive layer may have a configuration in which a film with high moisture permeability is sandwiched between die adhesives. With this configuration, a problem of occurrence of floating caused by aftercuring can be avoided. That is, the adhesive layer may have a multilayer structure in which a die adhesive layer, a film, and a die adhesive layer are laminated in this order.

The thickness of the adhesive layer may be appropriately set depending upon the purpose or the like. The thickness is, for example, about 5 to 100 µm, preferably about 10 to 50 µm.

### B. Production method for electronic component

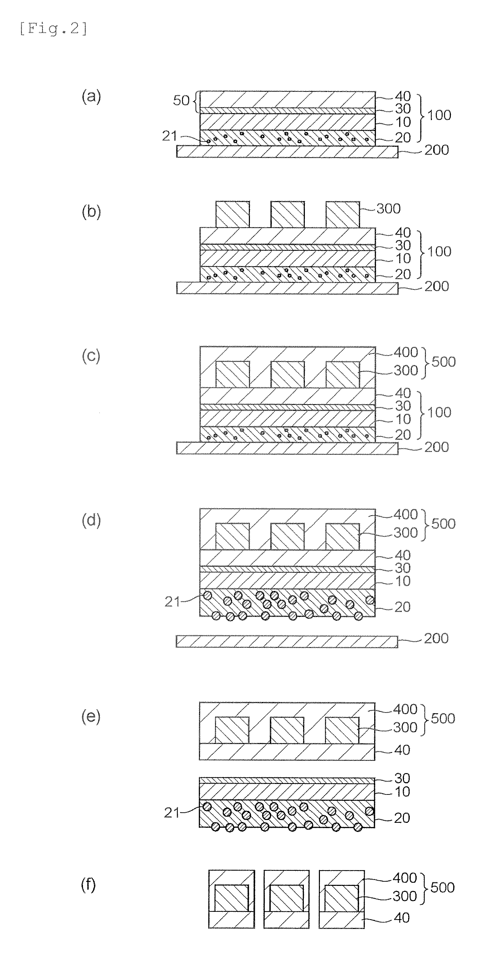

According to another aspect of the present invention, there is provided a production method for an electronic component. The production method for an electronic component includes:
[Step 1] attaching a pressure-sensitive adhesive sheet to a substrate, the pressure-sensitive adhesive sheet including a base, a thermally expandable pressure-sensitive adhesive layer containing thermally expandable microspheres provided on one surface of the base, and a dielectric layer including a weak pressure-sensitive adhesive layer and an adhesive layer provided on the other surface of the base in this order from the base side, so that the thermally expandable pressure-sensitive adhesive layer is placed on the substrate side;
[Step 2] attaching and fixing a plurality of chip-shaped electronic components to a surface of the pressure-sensitive adhesive sheet on the adhesive layer side so that electrode surfaces of the plurality of chip-shaped electronic components are placed on the adhesive layer side;
[Step 3] covering the entire surface of the plurality of chip-shaped electronic components excluding fixed surfaces with a protective substance to obtain an encapsulated body including the plurality of chip-shaped electronic components;
[Step 4] subjecting the pressure-sensitive adhesive sheet to heating treatment to cause the thermally expandable microspheres in the thermally expandable pressure-sensitive adhesive layer to expand to decrease an adhesion of the thermally expandable pressure-sensitive adhesive layer and peeling the thermally expandable pressure-sensitive adhesive layer from the substrate; [Step 5] peeling the weak pressure-sensitive adhesive layer from the adhesive layer to obtain a laminate of the adhesive layer and the encapsulated body; and
[Step 6] cutting the laminate between the plurality of chip-shaped electronic components to separate individual chip-shaped electronic components. According to the production method, a dielectric protective layer can be formed easily on electrode surfaces of chip-shaped electronic components. The production method of the present invention may include additional steps other than Steps 1 to 6, as required. The production method of the present invention is hereinafter described in detail with reference to FIG. **2*****.***

### B-1. Step 1

As illustrated in FIG. **2 (a)**, in Step 1, the pressure-sensitive adhesive sheet **100** of the present invention described in Section A above is attached to a substrate **200** so that the thermally expandable pressure-sensitive adhesive layer **20** is placed on the substrate **200** side.

Any appropriate substrate may be used as the substrate. As a material for forming the substrate, there are given, for example, quartz and glass.

The pressure-sensitive adhesive sheet described in Section A above may be preferably used as the pressure-sensitive adhesive sheet.

Any appropriate method and means may be employed as a method and means for the attachment without any particular limitation.

### B-2. Step 2

As illustrated in FIG. **2(b)**, in Step 2, a plurality of chip-shaped electronic components **300** are attached and fixed to a surface of the pressure-sensitive adhesive sheet **100** on the adhesive layer **40** side so that electrode surfaces of the chip-shaped electronic components **300** are placed on the adhesive layer **40** side.

The chip-shaped electronic components are typically semiconductor chips. The plurality of chip-shaped electronic components to be attached to the pressure-sensitive adhesive sheet may be the same or different.

The chip-shaped electronic components are preferably electronic components determined to be non-defective products by characteristic measurement. For example, in the case of semiconductor chips, each IC on a completed wafer is electrically checked to be determined to be a defective product or a non-defective product and subjected to dicing to be formed into chips. After that, only the non-defective products are picked up to be used. Through use of only non-defective electronic components, a yield increases, and hence a production cost can be reduced.

The chip-shaped electronic components are fixed when the electrode surfaces thereof are attached to a surface of the adhesive layer of the pressure-sensitive adhesive sheet. The fixing may be performed by crimping or bonding by thermal curing. The crimping is performed by a conventional method. There is no limitation to the way in which the chip-shaped electronic components are arranged. However, it is preferred that the chip-shaped electronic components be arranged in a grid shape at a predetermined interval from the viewpoint of workability of dicing.

### B-3. Step 3

As illustrated in FIG. **2(c)****,** in Step 3, the entire surface excluding fixed surfaces of the plurality of chip-shaped electronic components **300** is covered with a protective substance **400**. That is, the plurality of chip-shaped electronic components **300** are encapsulated with the protective substance **400**, to thereby obtain an encapsulated body **500** including the plurality of chip-shaped electronic components **300**.

Any material which may be used as a material for encapsulating a semiconductor may be used as the protective substance. The protective substance is preferably a thermosetting resin or a thermoplastic resin, more preferably a thermosetting resin. A specific example of the thermosetting resin is an epoxy-based resin.

The encapsulated body may be obtained, for example, by covering the entire surface excluding fixed surfaces of the plurality of chip-shaped electronic components with a protective substance, followed by thermal curing, by a transfer molding method, a dispenser method, or the like.

### B-4. Step 4

As illustrated in FIG. **2 (d)****,** in Step 4, the pressure-sensitive adhesive sheet **100** is subjected to heating treatment to cause the thermally expandable microspheres **21** in the thermally expandable pressure-sensitive adhesive layer **20** to expand to decrease its adhesion, and the thermally expandable pressure-sensitive adhesive layer **20** is peeled from the substrate **200**. The adhesion of the thermally expandable pressure-sensitive adhesive layer **20** is decreased remarkably through the heating treatment, and the peeling can be performed with small force without damaging the encapsulated body **500**.

A heating temperature in the heating treatment only needs to be equal to or higher than the expansion starting temperature of the thermally expandable microspheres. When the protective substance contains a thermosetting resin, the heating temperature is preferably equal to or higher than the curing temperature of the resin. Further, when the protective substance contains a thermoplastic resin, the heating temperature is preferably equal to or lower than the softening temperature of the resin. With such heating temperature, an encapsulated body having sufficient hardness can be obtained. A heating time may be set appropriately depending upon the heating temperature.

### B-5. Step 5

As illustrated in FIG. **2(e)****,** in Step 5, the weak pressure-sensitive adhesive layer **30** is peeled from the adhesive layer **40** to obtain a laminate of the adhesive layer **40** and the encapsulated body **500.** As described above, the weak pressure-sensitive adhesive layer **30** has satisfactory peel property with respect to a surface of the adhesive layer **40,** and hence can be peeled from the adhesive layer **40** without any adhesive residue. Consequently, a dielectric protective layer (adhesive layer **40**) having an accurately controlled thickness is formed on electrode surfaces of the chip-shaped electronic components **300**. As required, the obtained laminate may be heated to cure the adhesive layer sufficiently.

### B-6. Step 6

As illustrated in FIG. **2(f)****,** in Step 6, the laminate is cut between the plurality of chip-shaped electronic components to separate individual chip-shaped electronic components.

The cutting may be performed, for example, by crimping the laminate of the adhesive layer **40** and the encapsulated body **500** onto a dicing tape, and cutting the protective substance between the plurality of chip-shaped electronic components by any appropriate cutting means such as a rotary blade. Cracking and chipping can be prevented from occurring in the electronic components by cutting the protective substance.

Examples of the additional steps include a redistribution step, a reverse surface polishing step, and a terminal forming step. These steps are preferably performed between Steps 5 and 6. Through the cutting of the laminate after the redistribution and formation of structures required for packaging such as terminals on the encapsulated body in a collective manner, a semiconductor package in which the size of each cut chip is the size of a package can be obtained at low cost.

### Industrial Applicability

The production method and pressure-sensitive adhesive sheet of the present invention may be suitably used for production of a chip-shaped electronic component such as a semiconductor chip.

### Reference Signs List

- **10**: base

- **20**: thermally expandable pressure-sensitive adhesive layer
- **21**: thermally expandable microsphere
- **30**: weak pressure-sensitive adhesive layer
- **40**: adhesive layer
- **50**: dielectric layer
- **100**: pressure-sensitive adhesive sheet
- **200**: substrate
- **300**: chip-shaped electronic component
- **400**: protective substance
- **500**: encapsulated body

## Claims

1. A production method for an electronic component, comprising:
attaching a pressure-sensitive adhesive sheet to a substrate, the pressure-sensitive adhesive sheet including a base, a thermally expandable pressure-sensitive adhesive layer containing thermally expandable microspheres provided on one surface of the base, and a dielectric layer including a weak pressure-sensitive adhesive layer and an adhesive layer provided on another surface of the base in this order from a side of the base, so that the thermally expandable pressure-sensitive adhesive layer is placed on a side of the substrate;
attaching and fixing a plurality of chip-shaped electronic components to a surface of the pressure-sensitive adhesive sheet on a side of the adhesive layer so that electrode surfaces of the plurality of chip-shaped electronic components are placed on the side of the adhesive layer;
covering an entire surface of the plurality of chip-shaped electronic components excluding fixed surfaces with a protective substance to obtain an encapsulated body including the plurality of chip-shaped electronic components;
subjecting the pressure-sensitive adhesive sheet to heating treatment to cause the thermally expandable microspheres in the thermally expandable pressure-sensitive adhesive layer to expand to decrease an adhesion of the thermally expandable pressure-sensitive adhesive layer and peeling the thermally expandable pressure-sensitive adhesive layer from the substrate;
peeling the weak pressure-sensitive adhesive layer from the adhesive layer to obtain a laminate of the adhesive layer and the encapsulated body; and
cutting the laminate between the plurality of chip-shaped electronic components to separate individual chip-shaped electronic components.

2. A production method for an electronic component according to claim 1, wherein the protective substance contains a thermosetting resin or a thermoplastic resin, and a heating temperature in the heating treatment is equal to or higher than a curing temperature of the thermosetting resin or is equal to or lower than a softening temperature of the thermoplastic resin.

3. A pressure-sensitive adhesive sheet to be used in the production method for an electronic component according to claim 1 or 2, comprising:
a base;
a thermally expandable pressure-sensitive adhesive layer containing thermally expandable microspheres provided on one surface of the base; and
a dielectric layer including a weak pressure-sensitive adhesive layer and an adhesive layer provided on another surface of the base in this order from a side of the base.

4. A pressure-sensitive adhesive sheet according to claim 3, wherein a dielectric constant of the adhesive layer is 5 or less.

5. A pressure-sensitive adhesive sheet according to claim 3 or 4, wherein a water absorption rate of the adhesive layer is 2% or less.

6. A pressure-sensitive adhesive sheet according to any one of claims 3 to 5, wherein an adhesion of the weak pressure-sensitive adhesive layer with respect to the adhesive layer in an atmosphere of 23°C is 3 N/20 mm or less.

7. A pressure-sensitive adhesive sheet according to any one of claims 3 to 6, wherein the adhesion of the weak pressure-sensitive adhesive layer with respect to the adhesive layer in an atmosphere of 100°C is 2 N/20 mm or less.

8. A pressure-sensitive adhesive sheet according to any one of claims 3 to 7, wherein the protective substance contains a thermosetting resin, and an expansion starting temperature of the thermally expandable microspheres is equal to or higher than a curing temperature of the thermosetting resin.
